Europäisches Patentamt

European Patent Office

Office européen des brevets

(11) Veröffentlichungsnummer: **0 256 505**
**A1**

## (12) EUROPÄISCHE PATENTANMELDUNG

(21) Anmeldenummer: 87111662.0

(22) Anmeldetag: **12.08.87**

(51) Int. Cl.4: **H03C 1/60** , H03C 1/62

(30) Priorität: 16.08.86 DE 3627852

(43) Veröffentlichungstag der Anmeldung:
24.02.88 Patentblatt 88/08

(84) Benannte Vertragsstaaten:
CH DE FR GB LI

(71) Anmelder: **Licentia Patent-Verwaltungs-GmbH**
**Theodor-Stern-Kai 1**
**D-6000 Frankfurt/Main 70(DE)**

(72) Erfinder: **Zeis, Jürgen**
**Tutzinger Strasse 19**
**D-1000 Berlin 49(DE)**

(74) Vertreter: **Schulze, Harald Rudolf, Dipl.-Ing. et al**
**Licentia Patent-Verwaltungs-GmbH**
**Theodor-Stern-Kai 1**
**D-6000 Frankfurt/Main 70(DE)**

(54) Leistungssender, insbesondere Rundfunk-Leistungssender.

(57) Die Erfindung betrifft einen Leistungssender, insbesondere einen Einseitenband-Rundfunk-Leistungssender, der ein Einseitenbandsignal, z.B. gemäß den Sendearten H3E oder R3E, aussenden kann, das von einem Doppelseitenband (A3E)-Empfänger empfangbar ist. Bei dem Leistungssender ist eine vom Modulationssignal abhängige Steuerung und/oder Regelung des Träger-und/oder Einseitenbandsignals vorhanden, so daß ein kostengünstiger Sendebetrieb möglich ist.

F/G.1

EP 0 256 505 A1

Xerox Copy Centre

## "Leistungssender, insbesondere Rundfunk-Leistungssender"

Die Erfindung betrifft einen Leistunggsender, insbesondere einen Rundfunk-Leistungssender, nach dem Oberbegriff des Patentanspruchs 1.

Die Erfindung ist insbesondere anwendbar bei einem AM-Rundfunk-Leistungssender, der ein amplitudenmoduliertes Hochfrequenz-Trägersignal in der Doppelseitenbandsendeart A3E aussendet.

Aufgrund technischer und wirtschaftlicher Überlegungen ist geplant, den AM-Rundfunk auf nationaler und internationaler Ebene langfristig auf die Einseitenbandsendeart HE3 (mit 6dB Trägerabsenkung) oder R3E (mit z.B. 12 dB Trägerabsenkung) umzustellen. Da die Umstellung in einer Übergangsperiode von ca. 10 bis 20 Jahren erfolgt, müssen die Rundfunksender in der Lage sein, mit den genannten Sendearten Betrieb zu machen. Zumindest in der Übergangsperiode muß gewährleistet sein, daß mit AM-Empfängern mit Hüllkurvendemodulator Einseitenbandsendungen in akzeptabler Qualität empfangen werden können.

Der Erfindung liegt die Aufgabe zugrunde, einen gattungsgemäßen Leistungssender anzugeben, der zur Aussendung eines Einseitenbandsignals geeignet ist, das mit einem für Zweiseitenbandsendungen geeigneten Hüllkurvendemodulator-Empfägner in akzeptabler Qualität empfangbar ist, und der mit möglichst geringem Energieverbrauch und möglichst hoher Spitzenleistung arbeitet.

Diese Aufgabe wird gelöst durch die im kennzeichnenden Teil des Patentspruchs 1 angegebenen Merkmale. Vorteilhafte Ausgestaltungen und/oder Weiterbildungen sind den Unteransprüchen entnehmbar.

Die Erfindung geht davon aus, daß bei Einseitenbandbetrieb bei Großleistungssenderen derzeit zwei Betriebsweisen gebräuchlich sind:

1) Die Hochfrequenzstufe (RF-Stufe) des Senders arbeitet als Linearverstärker und wird mit einem vorstufenmodulierten Hochfrequenz (RF)-Signal ausgesteuert. Zur Verbesserung des Wirkungsgrades wird die Betriebsspannung (Anodenspannung) der Hochfrequenz-Endstufe mitgesteuert.

2. Der RF-Verstärker arbeitet wie bei der Doppelseitenbandsendeart A3E im überspannten C-Betrieb. Angesteuert wird der RF-Verstärker mit einem RF-Signal, das - abhängig vom Modulationssignal - phasenmoduliert ist, während der Modulationsverstärker mit einem Signal, das dem Hüllkurvenverlauf des vorstufenmodulierten RF-Signals entspricht, ausgesteuert wird. Dieses Verfahren wird Kahn-Verfahren genannt und ist z.B. beschrieben in Meinke/Gundlach: Taschenbuch der Hochfrequenztechnik, dritte Auflage (1968). S. 1329-1330.

Die zweite Betriebsweise hat einen besseren Wirkungsgrad als die erste. Es ist jedoch - schwieriger, hohe Linearitätsforderungen einzuhalten.

Für den Empfang von Einseitenbandsendungen mit Empfängern mit Hüllkurvendemodulator wird ein Sendebetrieb mit hohem Restträger von z.B. -6dB oder-4,6dB gefordert. Außerdem wird eine möglichst hohe Seitenbandleistung gefordert. Um bei Empfängern mit Hüllkurvendemodulator die gleiche Empfangsqualität zu erreichen wie beim Empfang der Sendeart A3E muß die Seitenbandleistung bei Einseitenband (SSB)-Betrieb 3dB höher sein. Beide Forderungen haben eine merkliche Steigerung der Betriebskosten zur Folge.

Erfindungsgemäß ist es nun möglich, durch die im Patentanspruch 1 angegebenen Merkmale die Betriebskosten zu senken und die Seitenbandleistung zu steigern unabhängig davon, ob nach der 1. oder 2. erwähnten Betriebsweise Einseitenbandbetrieb gemacht wird.

Besitzt ein Doppelseitenband-Sender eine dynamikabhängige Trägersteuerung, z.B. gemäß dem deutschen Patent DBP 3 037 902, so kann bei der Senderumrüstung auf Einseitenbandbetrieb das Signal zur Trägersteuerung mitbenutzt werden. Die dynamikabhängige Trägersteuerung ist unabhängig von der Aufbereitung des Einseitenbandsignals. Derzeit verbreitet sind die sogenannte Filtermethode und die sogenannte Phasenmethode. Dabei kann die Einseitenbandaufbereitung analog oder digital erfolgen. Setzt man einem Einseitenbandsignal einen Träger zu, dessen Höhe modulationsabhängig ist, dann kann man duch Wahl der Steuer-oder Regeleigenschaft Einfluß auf die Empfangsqualität (z.B. Störspannungsabstand, Klirrfaktor) eines Empfängers mit Hüllkurvendemodulator sowie auf die Betriebskosten (Energieverbrauch) des Senders nehmen. Optimal ist eine Absenkung der Trägeramplitude bei kleiner Modulations (NF)-Spannung und einer entsprechenden Anhebung bei großer Modulationsspannung, z.B. gemäß der in dem DBP 30 37 902 genannten Kennlinie.

Aus dieser Kennlinie (Trägeramplitude T in Abhängigkeit von dem Pegel P (Spitzenwert) der Modulations (NF)-spannung) geht hervor, daß bei einer immer kleiner werdenden Modulations(NF)-spannung die zugehörige Trägeramplitude lediglich bis zu einer vorgebbaren Rest-Trägeramplitude abgesenkt wird. Dadurch wird sichergestellt, daß auch ohne Modulations(NF)-spannung immer ein Rest-Trägersignal vorhanden ist. Dadurch werden vorteilhafterweise ansonsten vorhandene Störungen beim Rundfunkempfang vermieden. In Abhängigkeit von der gewählten Sendeart und/oder den vorherrschenden Sendebedingungen kann es sogar zweckmäßig sein, die Trägeramplitude bei dem Pegelwert P = O größe zu wählen als bei einem vorgebbaren kleinen Pegelwert $P = P_o > 0$. Eine derartige Kennlinie hat daher im Bereich zwischen den Regelwerten P = O und $P = P_o$ eine negative Steigung (negativer Kennlinienteil) und in dem Bereich zwischen $P_o$ und $P_{max}$ (maximaler Pegel) eine positive Steigung (positiver Kennlinienteil). Die Kennlinie besitzt also ein Minimum bei dem Pegelwert $P = P_o$. Mit derartigen Kennlinien ist eine Verbesserung der Empfangsqualität möglich.

Bei einem vorhandenen Netzgerät, dessen Leistungsabgabe durch die Betriebswerte für den A3E-Betrieb festliegt, gestattet eine Trägersteuerung und/oder Trägerregelung bei Einseitenbandmodulation einen Sendebetrieb mit höherer Spitzenleistung gegenüber einem Betrieb mit fester Trägeramplitude.

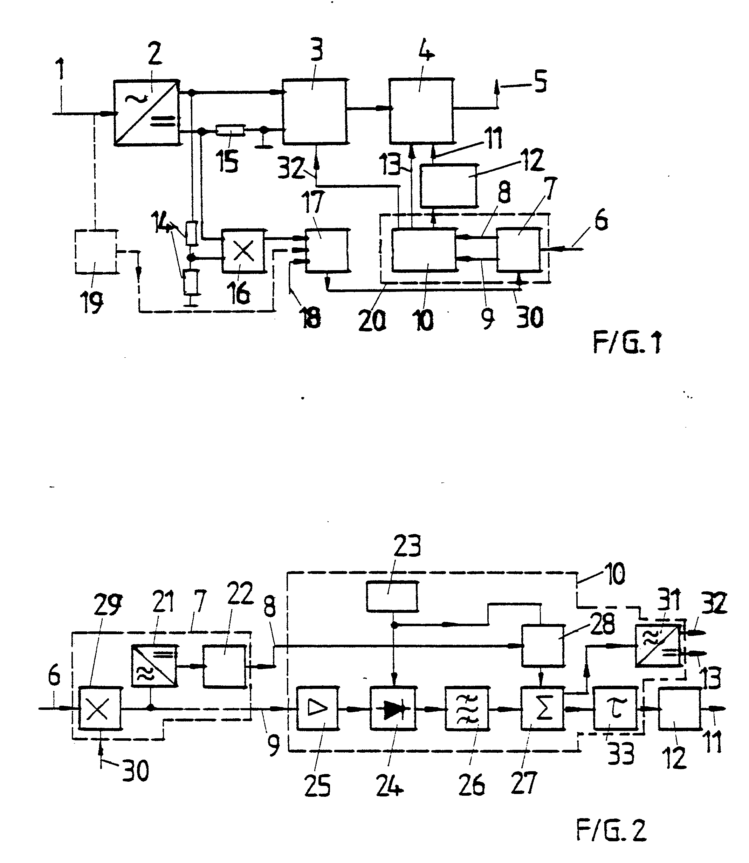

Bei A3E-Betrieb ist die Spitzenleistung bei einem Modulationsgrad m = 1 viermal so hoch wie die Trägerleistung. Der von der Stromversorgungseinheit (Netzgerät) abgegebene Leistung ist in diesem Fall - ein Wirkungsgrad der RF-Stufe von 100% angenommen - 50% höher als die Trägerleistung. Bei H3E-Betrieb ist die Spitzenleistung bei m = 1 ebenfalls viermal so hoch wie die Trägerleistung. Da die Leistungsabgabe der Stromversorgung (Netzgerät) festliegt, ist die Spitzenleistung bei H3E-Betrieb nur 75% der Spitzenleistung bei A3E-Betrieb unter Annahme von 100% Wirksungsgrad der Endstufe. Durch eine Reduzierung der Trägeramplitude bei verminderter Modulationsspannung und eine damit verbundene Reduzierung der Leistungsaufnahme ist eine Steigerung der Leistung bei Spitzenaussteuerung bis auf einen Wert entsprechend der Sendeart A3E möglich oder sogar höher soweit die RF-Stufe dazu in der Lage ist d.h. eine derartige erhöhte Leistung verarbeiten kann. An dem nachfolgenden Ausführungsbeispiel soll die Erfingung näher erläutert werden. Die Fig. 1 und 2 zeigen in schematischer Form Blockschaltbilder zur Erläuterung eines beispielhaften Einseitenbandsenders mit modulationsabhängiger Träger und/oder Seitenbandsteuerung.

Fig. 1 zeigt eine Netz-Versorgungsleitung 1, z.B. 3 x 220V 50Hz. Die Netzspannung wird in einem Netzgerät 2 transformiert und gleichgerichtet. Die entstandene Gleichspannung, z.B. 30 kV wird einem Modulationsverstärker 3 zugeführt, der eine mit einem niederfrequenten Signal modulierte Gleichspannung erzeugt zur Anodenmodulation der im RF-Verstärker 4 enthaltenen RF-Endstufe. Diese treibt eine Antenne 5. Das Modulationssignal 6 mit einer Bandbreite von z.B. 6 kHz wird zunächst einer Schaltungsanordnung (Fig. 2)zugeführt, in der ein für die dynamikabhängige Trägersteuerung, z.B. gemäß dem bereits erwähnten DBP 3 037 902, erforderliches Steuersignal 8 erzeugt wird. Dieses und das Modulationssignal werden einer Schaltungsanordnung 10 zugeführt, in der in derzeit geläufiger Weise eine Einseitenbandaufbereitung erfolgt, z.B. nach der Filter-oder Phasenmethode. Fig. 2 zeigt die Filtermethode.

Über eine Steuerleitung 11 sowie einen zwischengeschalteten Steuersender 12 wird der RF-Stufe 4 die erforderliche Trägerschwingung entsprechend der gewünschten Sendefrequenz zugeführt. Außerdem wird in der Schaltungsanordnung 10 ein niederfrequentes Steuersignal, das der Hüllkurve des Einseitenbandsignals 11 entspricht, erzeugt, welches den Modulationsverstärker 3 steuert und/oder regelt. Über eine Steuerleitung 13 wird der Arbeitspunkt der RF-Endstufe zur Verbesserung der Linearität gesteuert.

Die Steuerung und/oder Regelung der Trägerleistung und Seitenbandleistung in Abhängigkeit von der aus dem Netzgerät 2 entnommenen Leistung erfolgt mit Hilfe der im folgenden beschriebenen Anordnung. Mit Hilfe eines Spannungsteilers 14 und eines Reihenwiderstandes 15 werden an dem Netzgerät 2 die Gleichspannung und der entnommene Strom gemessen. Aus den Meßgrößen erzeugt ein Multiplizierer 16 ein Ausgangssignal entsprechend der abgegebenen Leistung, das einem Regler 17 zugeführt wird. Außerdem erhält der Regler 17 ein Referenzsignal 18, welches der abgebbaren maximalen Dauerleistung entspricht. Der Regler 17 erzeugt daraus ein Ausgangssignal, welches der Schaltungsanordnung 20 zugeführt wird und - wie in der Fig. 2 beispielhaft dargestellt - die Amplitude des Modulationssignales und damit die Amplitude von Träger-und Seitenband verändert. Weiterhin ist es möglich, die Leistungsaufnahme vor dem Netzgerät 2 mit einem Leistungsmesser 19 zu messen und in den Regler 17 einzugeben.

Die beschriebene Anordnung ist in vorteihafter Weise auf verschiedene Ausführungsformen eines Einseitenbandsenders anwendbar, z.B. auf die eingangs erwähnten unterschiedlichen Betriebsweisen und/oder unterschiedliche Funktionsweisen des Modulationsverstärkers 3.

Bei einer beispielhaft angenommenen sprunghaften Erhöhung der Amplitude des Modulationssignals 6 erzeugt die Schaltungsanordnung 7 ein Steuersignal 8, das einen sprunghaften Anstieg der Amplitude des Trägersignals bewirkt. Dabei wird dem Netzgerät 3 eine Leistung entnommen, die von dem Multiplizierer 16 ermittelt und an den Regler 17 weitergeleitet wird. Ist die Leistung größer als die Referenz 18, dann ist die Reaktion des Reglers 17 abhängig von der Höhe und der Zeit der Leistungsüberschreitung.

Ist die Leistungsüberschreitung nur kurzzeitig, z.B. kleiner gleich 3 Sekunden, dann erfolgt kein Steuer-und/oder Regelvorgang. Eine derartig kurze Leistungsüberschreitung ist für das Netzgerät 2 zulässig. Die thermische Zeitkonstante für die Netztransformatoren ist größer.

Ist die Leistungsüberschreitung länger, dann erfolgt nach Ablauf einer Totzeit ein Regelvorgang, durch den die Amplitude des Seitenbandsignals und des Trägers erniedrigt wird bis die durch den Multiplizierer 16 ermittelte Leistung des Netzgerätes 2 gleich dem Referenzwert ist. Bei Verringerung der Modulationssignal-Amplitude am Eingang 6 wird die vorhergehende Rückregelung durch den Regler 17 wieder aufgehoben.

Fig.2 zeigt in schematischer Form eine genauere Darstellung des in Fig. 1 mit 20 bezeichneten Teils der Anordnung. Das Modulationssignal 6 wird einem Multiplizierer 30 zugeführt, mit dem die Senderaussteuerung bei Leistungsüberschreitung des Netzteils 2 reduziert werden kann. An den Multiplizierer 30 sind ein Gleichrichter 21 und eine Bewertungsanordnung 22, z.B. entsprechend DBP 30 37 902, angeschlossen. Es entsteht ein Steuersignal 8, das eine vom Modulationssignal 6 abhängige Steuerung und/oder Regelung des Trägersignals ermöglicht. Bei einer beispielhaft gewählten Einseitenbandaufbereitung nach der sogenannten Filtermethode besteht die Schaltungsanordnung 10 im wesentlichen aus einem Frequenzgenerator 23 oder einer Signalquelle, deren Frequenzstabilität von Steuersender 12 abgeleitet ist, die einen Mischer 24 mit einer Schaltspannung mit 200 kHz speist. Die Signalspannung ist das vom Multiplizierer 30 geregelte und dem Verstärker 25 verstärkte Modulationssignal. An den Mischerausgang ist ein Filter 26 angeschlossen, daß das gewünschte Seitenband ausfiltert. Diesem Seitenbandsignal wird in einer Addierschaltung 27 ein Trägersignal zugesetzt, dessen Amplitude von der Amplitude des Moduationssignals gesteuert wird. Dazu wird eine Spannung des Frequenzgenerators 23 z.B. einem regelbaren Verstärker 28 zugeführt, dessen Verstärkung durch das Steuersignal 8 beeinflußt wird. Das Ausgangssignal des Addierers 27 gelangt auf einen Hüllkurvengleichrichter 31, der seinerseits zwei Signale 32, 13 zur Steuerung des Modulationsverstärkers 3 bzw. zur Steuerung der RF-Endstufe im RF-Verstärker 4 abgibt. Außerdem wird das Ausgangssignal des Addierers 27, nachdem es ein Laufzeitglied 33 passiert hat, im folgenden Steuersender 12 auf die Sendefrequenz umgesetzt zur Ansteuerung des RF-Verstärkers 4. Mit dem Laufzeitglied 33 wird die zeitliche Übereinstimmung des RF-Signals mit der mitgesteuerten Anodenspannung an der Anode der RF-Endstufe eingestellt.

Die Erfindung ist nicht auf das beschriebene Ausführungsbeispiel beschränkt sondern sinngemäß auf weitere anwendbar, beispielsweise auf die Sendeart R3E mit freiwählbarem Trägerzusatz und auf nicht im Beispiel genannte Aufbereitungsverfahren, z.B. Phasenmethode oder digitale Signalaufbereitung.

**Ansprüche**

1. Leistungssender, insbesondere Rundfunk-Leistungssender, zum Aussenden einer modulierten Hochfrequenz-Trägerschwingung, die einen amplitudenmodulierten Anteil besitzt, dadurch gekennzeichnet,
-daß eine erste Schaltungsanordnung (23, 24, 26) vorhanden ist, die einen Einseitenband-Betrieb des Leistungssenders ermöglicht,
-daß eine zweite Schaltungsanordnung (23, 28, 27) vorhanden ist, durch welche dem auszusendenden Einseitenbandsignal eine hochfrequente Trägerschwingung hinzufügbar ist mit einer Amplitude, welche den Empfang des Einseitenbandsignals mit Hilfe eines AM-Hüllkurvendetektors ermöglich, und
-daß die Amplitude der Trägerschwingung und/oder die Amplitude des Einseitenbandsignals in Abhängigkeit von der Amplitude des Modulationssignals derart beeinflußbar ist (sind), daß ein hoher Aussteuergrad des amplitudenmodulierten Anteils erreichbar ist.

2. Leistungssender nach Anspruch 1, dadurch gekennzeichnet, daß in dem ausgesandten Signal die Amplitude der Hochfrequenz-Trägerschwingung immer größer gleich der Amplitude des Einseitenbandsignals ist.

3. Leistungssender nach Anspruch 1 oder Anspruch 2, dadurch gekennzeichnet, daß das Einseitenbandsignal das obere Seitenband enthält.

4. Leistungssender nach einem der vorhergehenden Ansprüche, dadurch gekennzeichnet, daß der Modulationsgrad des amplitudenmodulierten Anteils steuer-oder regelbar ist gemäß einer Kennlinie, in welcher die Empfangsbedingungen des Senders berücksichtigt sind.

5. Leistungssender nach einem der vorhergehenden Ansprüche, dadurch gekennzeichnet, daß bei einer kleinen Amplitude des Modulationssignales die Amplitude der hochfrequenten Trägerschwingung wieder erhöht wird, zur Verbesserung der Empfangsqualität.

6. Leistungssender nach einem der vorhergehenden Ansprüche dadurch gekennzeichnet, daß bei dem Leistungssender fortlaufend die abgegebene elektrische Leistung des Netzgerätes (2) bestimmbar ist, und daß in Abhängigkeit von dieser Leistung die Amplitude der Hochfrequenz-Trägerschwingung und/oder die Amplitude des Einseitenbandsignals derart steuer-und/oder regelbar ist (sind), daß ein Überschreiten einer maximalen Dauerleistung des Netzgerätes (2) im wesentlichen vermieden wird.

7. Leistungssender nach einem der vorhergehenden Ansprüche dadurch gekennzeichnet, daß die aufgenommene Leistung des Netzgerätes (2) fortlaufend gemessen wird und daß in Abhängigkeit davon die Amplitude der Hochfrequenzträgerschwingung und/oder die Amplitude des Einseitenbandsignals derart steuer-und/oder regelbar ist (sind), daß ein Überschreiten einer maximalen Dauerleistung des Netzgerätes (2) im wesentlichen vermieden wird.

8. Leistungssender nach einem der vorhergehenden Ansprüche, dadurch gekennzeichnet, daß bei dem Netzgerät (2) ein kurzzeitiges Überschreiten der maximalen Dauerleistung möglich ist und daß bei einem längerfristigen Überschreiten solange eine Erniedrigung der Amplitude der Hochfrequenz-Trägerschwingung und/oder der Amplitude des Einseitenbandsignals erfolgt bis die dem Netzgerät (2) entnommene Leistung kleiner gleich der maximalen Dauerleistung ist.

9. Leistungssender nach einem der vorhergehenden Ansprüche, dadurch gekennzeichnet, daß das kurzfristige Überschreiten der maximalen Dauerleistung lediglich auf einige Sekunden begrenzt ist und daß danach eine Erniedrigung der Amplitude der Hochfrequenz-Trägerschwingung und/oder der Amplitude des Einseitenbandsignales mit einer Zeitkonstanten von einigen Sekunden erfolgt.

10. Leistungssender nach einem der vorhergehenden Ansprüche, dadurch gekennzeichnet, daß die Zeitkonstante derart gewählt ist, daß störende Verzerrungen und/oder störende Randaussendungen vermieden werden.

11. Leistungssender nach einem der vorhergehenden Ansprüche, dadurch gekennzeichnet, daß ein Hochfrequenz (RF)-Verstärker sowie ein Modulationsverstärker vorhanden sind und daß Hochfrequenz-und Modulationsverstärker entsprechend dem Kahn-Verfahren angesteuert sind.

F/G.1

F/G.2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | FR-A-1 248 074 (NOEL)<br>* Seite 1, linke Spalte, Zeile 1 - Seite 4, linke Spalte, Zeile 15; Figur 2 * | 1-3 | H 03 C 1/60<br>H 03 C 1/62 |
| Y | | 4-7,10, 11 | |
| Y | EP-A-0 137 121 (BBC)<br>* Seite 5, Zeile 11 - Seite 9, Zeile 6; Figuren 1-3 * | 4,5 | |
| Y | US-A-3 469 192 (HARUKI TOMONO)<br>* Spalte 1, Zeilen 61-69; Spalte 3, Zeile 3 - Spalte 4, Zeile 63; Figuren 2-4 * | 6,7 | |
| A | | 8,9 | |
| Y | DE-A-3 037 901 (LICENTIA)<br>* Seite 11, Zeile 12 - Seite 17, Zeile 24; Figuren 1-4 * | 10 | |
| A,D | DE-A-3 037 902 (LICENTIA)<br>* Seite 7, Zeile 24 - Seite 11, Zeile 17; Figuren 2-4 * | 1 | **RECHERCHIERTE SACHGEBIETE (Int. Cl.4)**<br><br>H 03 C<br>H 03 L |
| Y | PROCEEDINGS OF THE I.R.E., Band 40, Nr. 7, Juli 1952, Seiten 803-806, The Institute of Radio Engineers Inc., New York, US; L.R. KAHN: "Single-sideband transmission by envelope elimination and restoration"<br>* Figuren 2,3 * | 11 | H 03 F |

Der vorliegende Recherchenbericht wurde für alle Patentansprüche erstellt

| Recherchenort | Abschlußdatum der Recherche | Prüfer |
|---|---|---|
| DEN HAAG | 24-11-1987 | BALBINOT H. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
........................................................
& : Mitglied der gleichen Patentfamilie, übereinstimmendes
    Dokument

EPO FORM 1503 03.82 (P0403)